(19) Europäisches Patentamt
European Patent Office
Office européen des brevets

(11) **EP 1 935 004 B1**

(12) **EUROPÄISCHE PATENTSCHRIFT**

(45) Veröffentlichungstag und Bekanntmachung des Hinweises auf die Patenterteilung:
**07.01.2009 Patentblatt 2009/02**

(51) Int Cl.:
***H01L 21/00*** *(2006.01)*    ***C23C 16/44*** *(2006.01)*
***C23C 16/509*** *(2006.01)*

(21) Anmeldenummer: **06791415.0**

(22) Anmeldetag: **13.10.2006**

(86) Internationale Anmeldenummer:
**PCT/DE2006/001809**

(87) Internationale Veröffentlichungsnummer:
**WO 2007/042017 (19.04.2007 Gazette 2007/16)**

(54) **VORRICHTUNG UND VERFAHREN ZUR PLASMABEHANDLUNG VON OBJEKTEN**

PROCESS AND DEVICE FOR THE PLASMA TREATMENT OF OBJECTS

DISPOSITIF ET PROCEDE DE TRAITEMENT D'OBJETS AU PLASMA

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **14.10.2005 DE 102005049266**

(43) Veröffentlichungstag der Anmeldung:
**25.06.2008 Patentblatt 2008/26**

(73) Patentinhaber: **Fraunhofer-Gesellschaft zur Förderung der angewandten Forschung e.V.
80686 München (DE)**

(72) Erfinder: **MEIER, Sven
79104 Freiburg (DE)**

(74) Vertreter: **Gagel, Roland
Patentanwalt Dr. Roland Gagel
Landsberger Strasse 480a
81241 München (DE)**

(56) Entgegenhaltungen:
WO-A2-03/030240           JP-A- 10 083 899
JP-A- 58 064 023          JP-A- 61 295 374

## Beschreibung

### Technisches Anwendungsgebiet

Die vorliegende Erfindung betrifft eine Vorrichtung zur Plasmabehandlung von Objekten, mit einer Plasmakammer, in der zumindest eine Elektrode als Objektträger angeordnet ist und zumindest ein Wandbereich der Plasmakammer und/oder zumindest ein in der Plasmakammer angeordnetes Bauteil eine Gegenelektrode bildet, und einer Hochfrequenzeinheit, mit der durch Anlegen einer hochfrequenten Wechselspannung zwischen Elektrode und Gegenelektrode ein Plasma in der Plasmakammer erzeugbar ist. Die Erfindung betrifft auch ein Verfahren zur Plasmabehandlung von Objekten, bei dem durch Anlegen einer hochfrequenten Wechselspannung zwischen zumindest einer Elektrode und zumindest einer Gegenelektrode ein Plasma erzeugt und eine Oberfläche ein oder mehrerer auf der Elektrode gelagerter Objekte durch aus dem Plasma auf die Oberfläche auftreffende reaktive Ionen behandelt, insbesondere beschichtet oder geätzt wird.

In der Niederdruck-Zerstäubungs- und Beschichtungstechnik, einem bevorzugten Anwendungsgebiet der vorliegenden Erfindung, wurden in den letzten Jahren zahlreiche Verfahrensvarianten entwickelt. Ein gemeinsames Merkmal dieser Verfahrensvarianten ist eine Gasentladung (Plasma), mit der Ionen erzeugt und auf die zu zerstäubende oder zu beschichtende Oberfläche beschleunigt werden. Die einzelnen Objekte können dabei je nach Auslegung des Verfahrens oder der Anlage beschichtet oder geätzt werden. Die Gasentladung wird in einem Elektrodensystem aufrechterhalten, in dem der Objektträger durch eine der Elektroden gebildet wird.

### Stand der Technik

Häufig zum Einsatz kommende Ätz- bzw. Beschichtungstechniken sind das PECVD (Plasma Enhanced Chemical Vapor Deposition) sowie das PVD (Physical Vapor Deposition). Die beiden Verfahren unterscheiden sich vor allem dadurch, dass beim PECVD alle für den Ätz- bzw. Beschichtungsvorgang notwendigen Ausgangsstoffe dem Rezipienten in gasförmiger Form zugeführt werden, während beim PVD ein Teil der Ausgangsstoffe in fester Form, als Target, innerhalb des Rezipienten vorliegt und durch physikalische Vorgänge, bspw. Sputtern oder Elektronenstrahlverdampfen, in die Gasphase überführt wird. Je nach freizusetzendem Material werden die Targets hierbei mit Spannungen verschiedener Frequenzen bzw. Gleichspannung beaufschlagt.

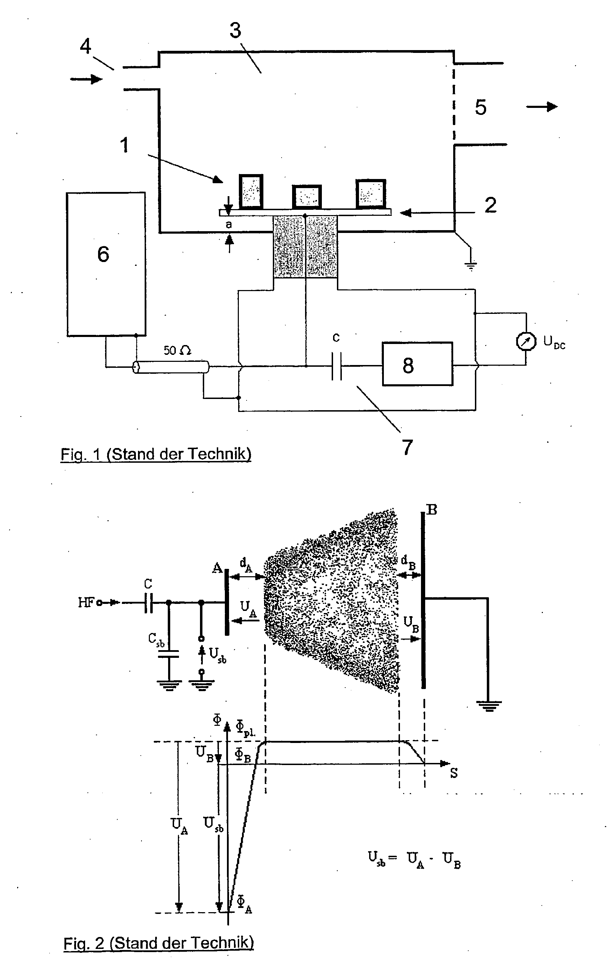

Figur 1 zeigt beispielhaft einen typischen Aufbau einer PECVD-Anlage. Die dargestellte Anlage weist eine Vakuum- oder Plasmakammer 3 auf, in der die Gasentladung gezündet wird. In der Plasmakammer 3 ist hierzu eine Elektrode 2 angeordnet, die den Objektträger für die Aufnahme der zu beschichtenden Objekte 1 bildet. Die Plasmakammer 3 selbst bildet die Gegenelektrode für die Plasmaerzeugung. Über eine Zuführung 4 werden ein Inertgas, bspw. Argon, sowie die für die Behandlung erforderlichen Reaktivgase in die Plasmakammer 3 eingeleitet. Die Gase werden über eine Abführung 5 von einer Pumpe wieder abgesaugt. Im unteren Teil der Figur ist die Versorgungselektronik mit einem HF-Generator 6 und einer Anpassungsschaltung 7 mit einem Filter 8 zu erkennen.

Eine derartige PECVD-Anlage eignet sich zur Herstellung elektrisch isolierender Schichten, die den Einsatz hochfrequenter Spannungen für die Plasmaerzeugung erfordern. Bei Anlegen einer ausreichend hohen Wechselspannung zwischen den Elektroden des Elektrodensystems wird bei geeigneter Abstimmung des Abstandes der Elektroden, des Gasdrucks sowie der eingesetzten Gasart die Gasentladung gezündet, so dass sich ein Plasma bildet. Die Elektronen in diesem Plasma oszillieren aufgrund der Wechselspannung und können dadurch genügend Energie aus dem Feld aufnehmen, um die Entladung aufrechtzuerhalten. Selbst wenn die Elektroden während des Prozesses mit einem isolierenden Material bedeckt werden, insbesondere bei der Abscheidung elektrisch isolierender Schichten, kann die Entladung aufrechterhalten werden.

Aufgrund ihrer geringen Masse können nur die Elektronen dem Hochfrequenzfeld folgen. Während der positiven Halbwelle erreichen daher erheblich mehr Elektronen die den Objektträger bildende Elektrode, im Folgenden auch als Objektelektrode bezeichnet, als Ionen während der negativen Halbwelle. Da die Objektelektrode durch den Anpassungskondensator der Anpassungsschaltung kapazitiv entkoppelt ist, lädt sie sich negativ auf. Die auf die Objektelektrode gelangten und nicht durch positive Ladungen kompensierten Elektronen können aufgrund dieser Anordnung nicht abfließen. Die entstehende Spannung wird als Selfbias-Spannung $(U_{sb})$ bezeichnet.

Die Selfbias-Spannung ist im symmetrischen Elektrodensystem relativ gering, u.a. aufgrund der hohen elektrischen Leitfähigkeit des neutralen Plasmas. Zur Verstärkung der Selfbias-Spannung und um für die Plasmabehandlung ausreichend hohe Ionenenergien zu erzielen, wird die mit der HF-Spannung beaufschlagte Objektelektrode bei bekannten Anlagen kleiner ausgeführt $(F_A < F_B)$ als die in der Regel geerdete Gegenelektrode, wie dies in Figur 2 schematisch aufgezeigt ist. Die aus den Randgebieten der neutralen Plasmasäule zu extrahierende Stromdichte ist nahezu konstant. Auf der eingeengten Seite können dadurch weniger Ionen die neutrale Plasmasäule verlassen. Aus Gründen der Stromkontinuität müssen über eine HF-Periode hinweg allerdings gleich viel Ionen und Elektronen auf die Objektelektrode gelangen. Ohne Änderung der von außen messbaren HF-Spannung spannt sich die kleinere Objektelektrode dadurch noch weiter negativ vor $(U_A >> U_B)$, um genügend Ionen zur Aufrechterhaltung der Stromkontinuität anziehen zu können. Es gilt:

$$U_0 \cong \frac{U_A}{U_B} = \left(\frac{F_B}{F_A}\right)^4$$

$U_A$, $U_B$: Selfbias-Teilspannungen $U_{sb} \cong U_A$ (in praktischen Systemen ist $U_B$ vergleichsweise klein)

$$U_{sb} \approx -U_0 - \frac{U_S}{2} \cdot \ln \frac{m_i}{4\pi \cdot m_e}$$

$U_0$: Amplitude der HF-Spannung
$U_s$: Spannungsabfall Grenzschicht
$m_i$, $m_e$: Ionen-, Elektronenmasse

Bei genauer Beobachtung eines solchen Plasmas sind vor den beiden Elektroden nichtleuchtende Zonen zu erkennen, die so genannten Dunkelräume. Diese variieren vor der aktiven Elektrode mit der anliegenden Spannung, werden im Extremfall des Elektronensättigungsstroms zu Null und im Moment der negativsten Spannung der Elektrode gegenüber dem Plasma maximal (Ionensättigungsstrom). Da die Leitfähigkeit des neutralen Plasmas sehr hoch ist, fällt praktisch die gesamte HF-Spannung und die systemabhängig gebildete Selfbias-Spannung $U_{sb}$ über den beiden Dunkelräumen ab, während das Plasma ein räumlich nahezu konstantes Potential besitzt (Plasmapotential). Es befindet sich im Ladungsträgergleichgewicht. Es ist quasineutral, da es sich gegen Störfelder, im einfachsten Fall Ionen, effektiv abschirmt (Debye-Länge). Praktische Anlagen werden durch geeignete Wahl des Plasmaraums und der aktiven Flächen so ausgelegt, dass die Spannung über dem Dunkelraum der größeren geerdeten Elektrode ($U_B$) nahezu Null wird. Die über einen HF-Filter messbare Selfbias-Spannung ist für Prozessdrücke unter 1 Pa dann ein direktes Maß für die Ionenenergie ($E_i = e \cdot U_{sb}$), da ein Energieverlust durch Stöße im Dunkelraum bei niedrigem Druck unwahrscheinlich wird. Aufgrund der Multifunktionalität der Dunkelräume (abschirmen, beschleunigen) verbunden mit der durch sie stattfindenden Quasigleichrichtung des HF-Stroms, wird ein nahezu kontinuierlich stattfindender Ionenbeschuss der aktiven Elektroden erreicht. Die praktisch verwendete Selfbias-Spannung ist daher ein Maß für die Unsymmetrie der verwendeten Anordnung.

In Abweichung zu Figur 1 ist auch die Verwendung einer positiven Selfbias möglich. In diesem Fall werden die zu behandelnden Objekte auf der jetzt kleineren geerdeten Anode abgelegt. Die physikalischen Vorgänge sind aber identisch. Gleiches gilt auch für PVD-Prozesse bzw. Sputteranlagen, die eine Objektbias durch HF-Anregung verwenden.

Aus den genannten physikalischen Randbedingungen leitet sich jedoch ein großer Nachteil dieser Beschichtungstechnologie ab. Zur Aufrechterhaltung der Stromkontinuität werden alle am Prozess beteiligten aktiven Flächen mit dem gleichen Strom an Elektronen und Ionen beaufschlagt. Für den unter Figur 1 abgebildeten und die bereits erwähnten Anlagentypen bedeutet das, dass der gleiche Ionenfluss, der auf die kathodisch geschalteten Bauteile trifft, auch auf die Anode fließt. Im Falle der Verwendung von Reaktivgasen wird der durch die Ionen transportierte Massenstrom zu gleichen Teilen sowohl auf den kathodisch geschalteten Bauteilen aber auch auf der geerdeten Anode abgeschieden. Die Anode wird dadurch verunreinigt.

In der Praxis wird dieses Problem reduziert, indem große Unterschiede im Flächenverhältnis von Anode und Kathode gewählt werden. Dadurch wird der anodische Dunkelraum sehr klein und dessen Kapazität sehr groß. Der daraus folgende niedrige HF-Widerstand verursacht ein relativ niedriges Dunkelraumpotential, welches unterhalb der Sputterschwelle liegt und eine Zerstörung der Anode verhindert. Des weiteren verteilt sich der anodische Niederschlag auf einer sehr viel größeren Fläche als auf der Kathode. Damit ist deren Reinigung bzw. das Auswechseln der allgemein üblichen Inlayers erst nach mehreren Prozessen notwendig.

Durch die branchenübergreifende Verwendung von Plasmaverfahren und die große Anzahl von existierenden Anlagen in Industrie und Forschung besitzt diese Problematik sehr allgemeingültigen Charakter und verursacht jährlich Aufwendungen an Zeit und Material in beträchtlicher Höhe. So müssen nach entsprechenden Prozessschritten in Anlagen der Halbleiterindustrie Reinigungsprozesse nachgeschaltet werden, die unter Verwendung aggressiver/giftiger Precursor oft ein Vielfaches der Zeit der eigentlichen Nutzprozesse benötigen. Zusätzlich verursachen die aggressiven Reinigungsgase Korrosion im Innern der Anlagen, so dass in regelmäßigen Abständen teure Stillstands- und Wiederanlaufvorgänge erforderlich sind.

Bei der Herstellung von dicken diamantähnlichen Schichten, sog. DLC-Schichten, führen die obigen physikalischen Randbedingungen auch zu Machbarkeitsproblemen. Die Herstellung von DLC-Schichten mit Schichtdicken von mehr als $10\mu m$ und Prozessparametern, die ein gezieltes Wachstum mit Strukturen ermöglichen, erfordert hohe Plasmadichten mit geringen Molekelverweildauern. Um die dafür benötigten hohen Wirkleistungen ins Plasma einkoppeln zu können und dabei moderate Biasspannungen beizubehalten, sind geringe Unterschiede in den aktiven Flächenverhältnissen von Anode zu Kathode notwendig. Hohe Schichtdicken bei kleinen Flächenverhältnissen führen jedoch zu einer massiven Belegung der Anode mit isolierenden Schichten. Durch die Geometrie von zu beschichtendem Bauteil und Plasmakammer und die daraus bedingten Inhomogenitäten in der elektrischen Feldverteilung und dem Gasfluss wird die Anode nicht gleichmäßig belegt. In Kombination mit den verhältnismäßig kleinen Anodenfällen bilden sich über den stärker isolierenden Bereichen (dicker belegte Bereiche) Raumladungen, die nicht kompensiert werden. Die entstehenden anodischen Bogenentladungen, sog. Arcs (Kurzschluss des anodischen Dunkelraums), behindern bzw. verhindern längere Plasmaprozesse zur Herstellung elektrisch isolierender Schichten. In der Praxis muss zudem nach jedem dieser Prozesse eine Komplettreinigung der Anlage erfolgen.

Die oben beschriebenen Nachteile behindern bis heute massiv die Verbreitung von dicken isolierenden Schichten (z.B. a-C:H-Schichten) trotz oft herausragender Eigenschaften und der Eignung in vielen Anwendungen.

JP-A-58-64 023 offenbart eine PECVD-Vorrichtung, bei der die zu beschichtenden Substrate in einer Kammer und die Elektroden außen angebracht sind.

JP-A-10-83899 offenbart eine Vorrichtung mit einer Plasma Kammer, die durch Wände mit jeweils einer Öffnung in drei Volumina unterteilt ist, wobei die eine Wand als Neutralisierungselektrode wirkt. Es werden dadurch Neutralteilchen herausgefiltert, die auf ein Substrat treffen.

Die Aufgabe der vorliegenden Erfindung besteht darin, eine Vorrichtung sowie ein Verfahren zur Plasmabehandlung von Objekten anzugeben, die zur Abscheidung sowohl elektrisch leitfähiger als auch dicker isolierender Schichten geeignet sind und mit denen eine unerwünschte Abscheidung auf den Flächen der Gegenelektrode vermindert werden kann. Die Vorrichtung und das zugehörige Verfahren sollen dabei vor allem den bisher erforderlichen Reinigungsaufwand für diese Flächen, insbesondere die anodischen Flächen, verringern.

**Darstellung der Erfindung**

Die Aufgabe wird mit der Vorrichtung und dem Verfahren gemäß den Patentansprüchen 1 und 18 gelöst. Vorteilhafte Ausgestaltungen oder Weiterbildungen der Vorrichtung sowie des Verfahrens sind Gegenstand der Unteransprüche oder lassen sich der nachfolgenden Beschreibung sowie den Ausführungsbeispielen entnehmen.

Die vorliegende Vorrichtung umfasst eine Plasmakammer, in der zumindest eine Elektrode als Objektträger angeordnet ist und zumindest ein Wandbereich der Plasmakammer und/oder zumindest ein in der Plasmakammer angeordnetes Bauteil eine Gegenelektrode bildet, sowie eine mit der Elektrode verbundene Hochfrequenzeinheit, mit der durch Anlegen einer hochfrequenten Wechselspannung zwischen Elektrode und Gegenelektrode ein Plasma in der Plasmakammer erzeugbar ist. Die Plasmakammer ist bei der vorliegenden Vorrichtung durch eine Trenneinrichtung in zumindest zwei Teilvolumina aufgeteilt, von denen ein erstes Teilvolumen für ein Reaktivgas die Elektrode und ein zweites Teilvolumen für ein Inertgas einen bei der Plasmaerzeugung aktiven Bereich der Gegenelektrode beinhaltet. Die Trenneinrichtung ist so ausgestaltet, dass sie einen für die Erzeugung des Plasmas erforderlichen Elektronenaustausch im Plasma zwischen den Teilvolumina ermöglicht und eine Diffusionssperre für das Reaktivgas bilden kann.

Durch die Trenneinrichtung der vorliegenden Vorrichtung wird es möglich, die neutrale Plasmasäule in einen reaktiven und einen inerten Teil zu zerlegen, ohne ihre Einheit als Plasma zu zerstören. Beim Betrieb dieser Vorrichtung wird hierzu in das zur Elektrode offene erste Teilvolumen ein Reaktivgas eingeleitet oder darin erzeugt, während in das zur Gegenelektrode offene zweite Teilvolumen ein Inertgas eingeleitet wird. Die Begriffe Inertgas und Reaktivgas umfassen hierbei auch Mischungen unterschiedlicher Inertgase oder Reaktivgase. Durch die Trenneinrichtung sowie vorzugsweise die Aufrechterhaltung einer geeigneten Strömung des Inertgases wird eine Diffusion von Reaktivgas aus dem ersten Teilvolumen in das zweite Teilvolumen behindert oder nahezu vollständig unterdrückt. Somit werden bei einer als "Kathode" wirkenden Elektrode aus dem kathodisch aktiven Randschichtteil der neutralen Plasmasäule im ersten Teilvolumen die schichtbildenden Ionen extrahiert und auf die Elektrode gerichtet, während aus dem anodischen Teil im zweiten Teilvolumen lediglich Edelgasionen auf die die "Anode" darstellende Gegenelektrode auftreffen. Die Bildung von Ablagerungen auf der Gegenelektrode wird somit vermieden oder zumindest verringert. Die Stromkontinuität bleibt dennoch erhalten, da sowohl auf die "Kathode" als auch auf die "Anode" weiterhin identische Ladungsmengen gelangen. Aufgrund der Verbindung der ersten Elektrode mit der Hochfrequenzeinheit stellt die erste Elektrode bzw. das erste Teilvolumen die Plasmaquelle der Vorrichtung dar.

Mit der vorliegenden Vorrichtung und dem zugehörigen Verfahren wird durch die Aufteilung der Plasmasäule in einen reaktiven und einen inerten Anteil somit verhindert, dass größere Anteile an Reaktivgasionen, die für die Schichtbildung oder das Ätzen verantwortlich sind, auf die Gegenelektrode gelangen. Bei einer geeigneten Ausgestaltung der Trenneinrichtung, bei der die Diffusion von Reaktivgas in das zweite Teilvolumen nahezu vollständig verhindert wird, treten praktisch keine Ablagerungen mehr an der Gegenelektrode auf. Auf diese Weise wird der Reinigungsaufwand zur Reinigung der Flächen der Gegenelektrode in der Plasmakammer deutlich vermindert, so dass diese nur in sehr großen Zeitabständen einer Reinigung unterzogen werden muss.

Durch die zumindest deutlich verminderte Abscheidung auf den Flächen der Gegenelektrode wird vor allem die Herstellung der in der Beschreibungseinleitung genannten dicken isolierenden Schichten, insbesondere von DLC-Schichten, ohne Einschränkung in der Plasmaprozessdauer ermöglicht.

Die Trenneinrichtung stellt einen wesentlichen Bestandteil der vorliegenden Vorrichtung sowie des zugehörigen Verfahrens dar. Diese Trenneinrichtung kann in einer einfachen Ausgestaltung lediglich als Trennwand mit zumindest einer Durchlassöffnung für den Elektronenaustausch gebildet sein. Durch geeignete Zuführung des Inertgases über das zweite Teilvolumen kann dann ein Inertgasstrom in Richtung des ersten Teilvolumens aufrechterhalten werden, durch den eine Diffusion von Reaktivgasanteilen in den Inertgasbereich behindert wird. Die Zuführungen für das Inertgas und das Reaktivgas müssen hierzu in das zweite bzw. erste Teilvolumen münden. Die Trenneinrichtung wirkt hierbei einerseits als sog. Elektronengate (für den Elektronenaustausch) und andererseits als Diffusionssperre für das Reaktivgas.

Zur Verbesserung der Diffusionssperre wird in einer Ausgestaltung der vorliegenden Vorrichtung das zweite Teilvolumen mit einem geringeren Querschnitt senkrecht zur Durchflussrichtung des Inertgases aufgebaut als das erste Teilvolumen, wobei der Übergang vom zweiten zum ersten Teilvolumen an den ein oder mehreren Durchgangsöffnungen trichterförmig ausgestaltet ist.

In einer weiteren vorteilhaften Ausgestaltung ist zwischen den beiden Teilvolumina ein drittes Teilvolumen ausgebildet, das über entsprechende Durchgangsöffnungen mit den angrenzenden Teilvolumina verbunden ist. Aus diesem dritten Teilvolumen werden die einströmenden Gase abgesaugt, wodurch die Diffusion von Reaktivgas aus dem ersten in das zweite Teilvolumen ebenfalls gegenüber einer Trenneinrichtung mit einer einzigen Trennwand und einer einfachen Durchgangsöffnung deutlich reduziert wird.

Eine sehr vorteilhafte Ausgestaltung der vorliegenden Vorrichtung sieht als Trenneinrichtung zumindest eine Trennwand mit ein oder mehreren Durchgangsöffnungen vor, an denen ein besonders ausgestaltetes Durchströmungselement angeordnet ist. Dieses Durchströmungselement bildet in einer Ausgestaltung einen sich von der Durchgangsöffnung zunächst erweiternden Strömungsquerschnitt, der sich im Anschluss wieder verengt, wieder erweitert und wieder verengt. Das Durchströmungselement bildet einen Strömungskanal zwischen zweitem und erstem Teilvolumen, der zwischen Ein- und Ausströmöffnung somit zwei hintereinander geschaltete Strömungskammern aufweist, die über eine Strömungsverengung miteinander verbunden sind. Auf diese Weise wird eine sehr gute Diffusionssperre für das Reaktivgas erreicht, das zwar in dieses Durchströmungselement eintreten, jedoch aufgrund der höheren Gegenströmung des Inertgases kaum bis in das zweite Teilvolumen gelangen kann. Selbstverständlich kann das Element auch durch ein oder mehrere weitere Strömungskammern mit zwischenliegenden Verengungsabschnitten erweitert werden oder auch nur aus einem einfachen zylindrischen Element, z.B. einem Rohrabschnitt, gebildet sein. Das Material des Elektronengates ist beliebig, vorzugsweise ein dielektrisches Material, und wird genau wie die Trennwand zwischen dem ersten und zweiten Teilvolumen floatend angeordnet.

In einer bevorzugten Ausgestaltung der Vorrichtung mit ein oder mehreren derartigen Strömungselementen sind diese bei annähernd senkrechtem Verlauf der Trennwand annähernd waagrecht angeordnet. In diesem Fall bildet sich in der dem ersten Teilvolumen nächstgelegenen Strömungskammer im unteren Teil ein Niederschlag durch die Reaktivgasionen, der jedoch auch bei längerer Betriebsdauer die Plasmaerzeugung und Plasmabehandlung nicht beeinflusst.

Bei der vorliegenden Vorrichtung darf der elektrisch aktive Bereich der Gegenelektrode nicht im ersten Teilvolumen liegen. Dies erfordert, dass der Teil der Plasmakammer, der das erste Teilvolumen begrenzt, aus einem elektrisch isolierenden Material besteht (bspw. Glas oder Kunststoff) oder mit einem derartigen Material an der Innenseite bedeckt ist. In einer alternativen Ausgestaltung kann dieser Teil auch aus der Masse des Elektrodensystems entfernt werden. In diesem Fall muss jedoch die erforderliche Rückführung des HF-Stroms über andere Verbindungen erfolgen, so dass aufwendige Schirmungen eingesetzt werden müssen. Der Begriff der elektrisch aktiven Gegenelektrode betrifft hierbei vor allem eine Ausgestaltung, bei der die Wandung der Plasmakammer im zweiten Teilvolumen die Gegenelektrode bildet, im ersten Teilvolumen jedoch an der Innenseite mit einer elektrischen Isolation versehen ist. In diesem Falle wirkt nur der an das zweite Teilvolumen angrenzende Teil der Plasmakammer als Gegenelektrode. Dieser Bereich wird in der vorliegenden Patentanmeldung als aktiver Bereich der Gegenelektrode bezeichnet.

In einer bevorzugten Ausgestaltung der Vorrichtung ist eine zweite Plasmaquelle im Bereich des Elektronengates angeordnet. Um auch die Diffusion von geladenen Reaktivgasen (Reaktivgasionen durch ambipolare und feldgetriebene Diffusion) zu verhindern, muss die Plasmadichte im Inertgasbereich höher sein als im Reaktivgasbereich. Da der Plasma-Bulk nur theoretisch feldfrei ist, überlagert sich dem ambipolaren Diffusionsstrom noch ein feldgetriebener Diffusionsstrom zwischen der als "Kathode" wirkenden Elektrode im Reaktivgasbereich (erstes Teilvolumen) und der als "Anode" wirkenden Gegenelektrode im Inertgasbereich (zweites Teilvolumen). Durch die zweite Plasmaquelle wird dem entgegengewirkt. Diese reduziert die ambipolare Diffusion von Reaktivgasionen in den Inertgasbereich, sobald die Plasmadichte im Inertgasbereich höher ist als im Reaktivgasbereich. Gleichzeitig wird der Widerstand für den das Elektronengate passierenden HF-Strom herabgesetzt. Die Konstruktion des Elektronengates kann hierbei unterstützend wirken, wenn formbedingt eine lokale Überhöhung der Inertgas-Plasmadichte im Inertgas-Durchtritt generiert wird.

Die Art der Plasmaerzeugung bei der zweiten Plasmaquelle ist beliebig (DC-Plasma, induktiv gekoppeltes HF-Plasma, kapazitiv gekoppeltes HF-Plasma, Mikrowelle ...). Bevorzugt wird eine Plasmaerzeugung, welche einen möglichst geringen Einfluss auf die Entladung im Reaktivgasbereich hat und der speziellen Geometrie des Elektronengates problemlos angepasst werden kann. Demzufolge kann eine DC-Ring- bzw. DC-Gitterelektrode verwendet werden. Die DC kann auch gepulst werden.

Das auf die beschriebenen Arten aktiv gewordene Elektronengate wird bei dieser Ausgestaltung zu einer Plasmaquelle. Der Gesamtaufbau der Anlage stellt dadurch einen 3-Kammeraufbau dar, der neben der aktiven Reaktivgaskammer noch eine aktive und zumindest eine passive Inertgaskammer besitzt.

Die spannungsführende Elektrode des zweiten Plasmaerzeugungssystems wird vorzugsweise im vorderen Bereich des Elektronengates (Mündungsbereich nahe der Reaktivgaskammer) angeordnet. Als Gegenelektrode fungiert ebenfalls die geerdete Kesselwand des Inertgasbereichs. Um Ablagerungen im Mündungsbereich des Elektronengates zu vermeiden, wird eine Einrichtung zur Erzeugung eines geeigneten Magnetfeldes am Elektronengate angeordnet. Vorzugsweise wird hierzu eine Helmholtzspule verwendet, die über das Elektronengate geschoben wird. Das durch das Elektronengate greifende homogene Magnetfeld hindert Ladungsträger am Verlassen der Plasmasäule zwischen Inertgas- und Reaktivgasbereich und verbessert noch einmal die elektrische Leitfähigkeit innerhalb des Elektronengates.

Da die ambipolare Diffusion eine physikalische Gegebenheit eines jeden Plasmas ist, wird jede das Plasma begrenzende Fläche auch außerhalb der aktiven Flächen mit einem Ionenbeschuss belegt. Die einzige Möglichkeit dies zu verhindern besteht darin, die Bewegung von allen das Plasma verlassenden Ladungsträgern (positiven und negativen) durch ein Magnetfeld so zu manipulieren, dass sie die floatende Fläche nicht erreichen können. Alle nicht aktiven Flächen des Reaktivbereichs werden daher vorzugsweise analog zum aktiven Elektronengate mit einer Helmholtzspule bzw. mit einem System aus Helmholtzspulen überzogen, dessen Magnetfeld das Plasma zwischen HF-Austritt (Substrat- bzw. Elektrodenbeginn) und dem Elektronengate einschließt. Dafür müssen die resultierenden Magnetfeldlinien zwischen Elektrode und Elektronengate parallel zur floatenden Kesselwand des Reaktivgasbereichs verlaufen.

In einer weiteren Ausgestaltung der vorliegenden Vorrichtung wird die Plasmakammer hinsichtlich ihrer die Fläche der Gegenelektrode beeinflussenden Abmessungen variabel ausgeführt. Hierzu wird die Plasmakammer vorzugsweise so ausgestaltet, dass das zweite und evtl. auch das erste Teilvolumen über Zwischenringe oder einen anderen Mechanismus, z.B. einen Dreh- oder Verschiebemechanismus, in den Abmessungen verändert werden können. Hierdurch, z.B. durch Einbringen oder Entfernen von Zwischenringen, kann somit das jeweilige Teilvolumen vergrößert oder verkleinert werden, so dass das Flächenverhältnis von Elektrode und Gegenelektrode und somit die Beschichtungseigenschaften auf einfache Weise skaliert werden können.

## Kurze Beschreibung der Zeichnungen

Die vorliegende Vorrichtung und das zugehörige Verfahren werden nachfolgend anhand von Ausführungsbeispielen in Verbindung mit den Zeichnungen ohne Beschränkung des durch die Patentansprüche vorgegebenen Schutzbereichs nochmals näher erläutert. Hierbei zeigen:

Fig. 1    ein Beispiel für den Aufbau einer PECVD-Anlage des Standes der Technik;

Fig. 2    ein Beispiel für die räumliche Ausdehnung einer HF-Entladung gemäß dem Stand der Technik;

Fig. 3    ein erstes Beispiel einer Ausgestaltung der vorliegenden Vorrichtung;

Fig. 4    ein zweites Beispiel einer Ausgestaltung der vorliegenden Vorrichtung;

Fig. 5    ein drittes Beispiel einer Ausgestaltung der vorliegenden Vorrichtung;

Fig. 6    ein viertes Beispiel einer Ausgestaltung der vorliegenden Vorrichtung;

Fig. 7    ein Beispiel für eine besondere Ausgestaltung der Trenneinrichtung der vorliegenden Vorrichtung;

Fig. 8    ein weiteres Beispiel für eine besondere Ausgestaltung der Trenneinrichtung der vorliegenden Vorrichtung; und

Fig. 9    ein weiteres Beispiel für eine besondere Ausgestaltung der Trenneinrichtung der vorliegenden Vorrichtung.

## Wege zur Ausführung der Erfindung

Die Figuren 1 und 2 wurden bereits in der Beschreibungseinleitung in Zusammenhang mit dem Stand der Technik und den bisherigen Verhältnissen bei der Plasmaerzeugung näher erläutert. Bei diesen bekannten Techniken werden zur Aufrechterhaltung der Stromkontinuität alle am Prozess beteiligten aktiven Elektrodenflächen mit dem gleichen Strom an Elektronen und Ionen aus der neutralen Plasmasäule beaufschlagt. Dadurch wird ein identischer Massenstrom auf der Anode und der Katode abgeschieden. Die unerwünschte Abscheidung auf der Anode erfordert häufige sehr aufwendige Reinigungsprozesse.

Bei der vorliegenden Vorrichtung gemäß den nachfolgenden Ausführungsbeispielen werden die dem Plasmaprozess zugeführten Gase in einen Inert- und einem Reaktivgasstrom getrennt. Die neutrale Plasmasäule wird durch eine Trenneinrichtung zweigeteilt, wobei der einen Hälfte das Reaktivgas und der anderen das Inertgas zugeführt werden. Die Teilbereiche der neutralen Plasmasäule, im Folgenden als Inertgasbereich (entsprechend dem zweiten Teilvolumen) und Reaktivgasbereich (entsprechend dem ersten Teilvolumen) bezeichnet, werden durch ein in der Trenneinrichtung ausgebildetes Elektronengate verbunden, das gleichzeitig als Diffusionssperre für das Gas des Reaktivgasbereichs dient.

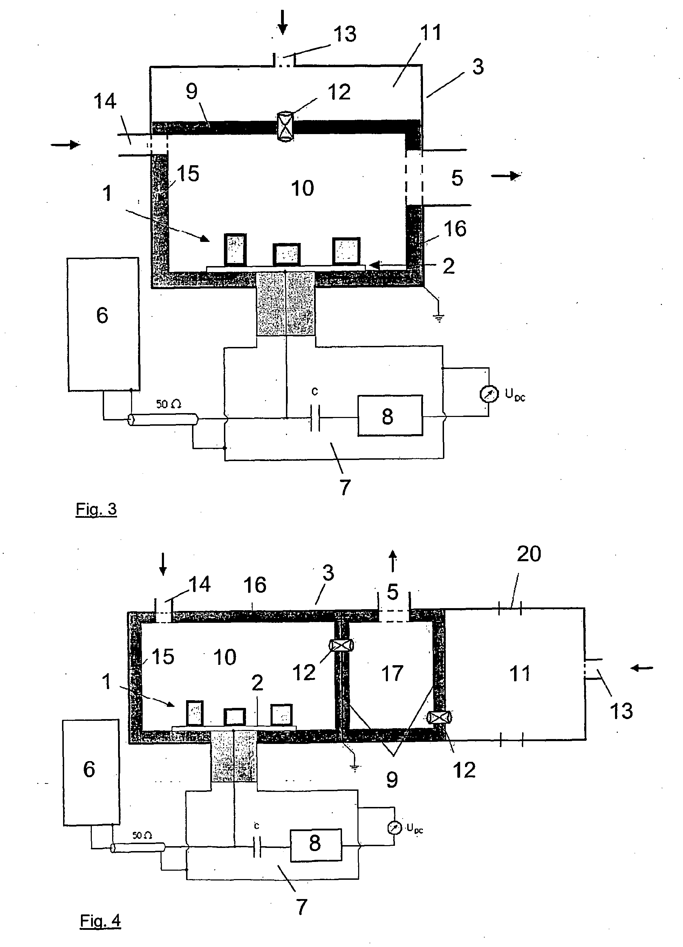

Figur 3 zeigt hierzu ein Beispiel für eine mögliche Ausgestaltung der vorliegenden Vorrichtung. Die Plasmakammer 3 ist in diesem Beispiel durch eine Trennwand 9 mit einem Elektronengate 12 in ein erstes Teilvolumen (Reaktivgasbereich 10) und ein zweites Teilvolumen (Inertgasbereich 11) aufgeteilt. Die konstruktive Ausgestaltung der Plasmakammer 3 sowie des Zuführungs- und Pumpsystems für die Gase ist so ausgeführt, dass das in den Reaktivgasbereich 10 eingeströmte Reaktivgas (z.B. $CH_4$) nicht oder nur zu einem geringen Anteil in den Inertgasbereich 11 gelangen kann. Der Reaktivgasbereich 10 weist hierzu eine Zuführung 14 für Reaktivgase sowie eine Abführung 5 zu Pumpe auf. Der Inertgasbereich 11 weist dementsprechend eine Zuführung 13 für Inertgase (z.B. Argon) auf. Die nicht kathodischen Teile des Reaktivgasbereichs 10 sind elektrisch isoliert. Sie können alternativ auch aus der HF-Masse entfernt oder aus einem elektrischen Isolator, bspw. aus Glas, gefertigt sein. Für die beiden letztgenannten Möglichkeiten muss eine HF-technisch geeignete und geschirmte Masseleitung vom Inertgasbereich 11 zur Innenseite des Anpassnetzwerks 7 realisiert werden. Die HF-Elektronik für den Betrieb der Plasmaentladung kann in gleicher Weise aufgebaut sein, wie dies bereits im Zusammenhang mit der Figur 1 erläutert wurde.

Im vorliegenden wie auch in den nachfolgenden Ausführungsbeispielen besteht die Plasmakammer 3 aus Aluminium oder Edelstahl 16. Die Wände der Plasmakammer sind im Reaktivgasbereich 10 mit einer elektrischen Isolierung 15 bedeckt, so dass der aktive Bereich der Gegenelektrode lediglich im Inertgasbereich 11 liegt.

Wird jetzt durch Anlegen einer hochfrequenten Spannung an die Elektrode 2, im vorliegenden Beispiel die Kathode, ein Plasma gezündet, so brennt die neutrale Plasmasäule im oberen und unteren Brennraum (Inertgasbereich 11 und Reaktivgasbereich 10) in der Form einer Hantel. Die bei einer HF-Entladung nahezu ortsfesten Ionen können aufgrund der Trenneinrichtung (Trennwand 9, Elektronengate 12) nicht in den jeweils anderen Brennraum gelangen. Lediglich neutrale Teile des Gases werden durch Diffusions- und Strömungsprozesse zwischen den Brennräumen ausgetauscht.

Die permanente Zuführung eines Inertgases im Inertgasbereich 11 ohne eigene Pump- bzw. Abführöffnung wirkt aber im Durchgangsbereich zwischen oberem und unterem Brennraum als Sperrgasstrom und verhindert bei geeigneter Ausführung das Eintreten von Reaktivgas in den Inertgasbereich 11. Wird der Durchgang zwischen den beiden Brennräumen so gestaltet, dass ein nahezu ungehinderter Austausch von Elektronen zwischen den beiden Teilen der neutralen Plasmasäule möglich ist, so ist im Reaktivgasbereich 10 (unterer Brennraum) lediglich die Kathode aktiv (Anode isoliert) und im Inertgasbereich 11 (oberer Brennraum) lediglich die elektrisch leitfähige Anode. Im Reaktivgasbereich fließen die für die Beschichtung wirksamen Ionen nur auf die Kathode und im Inertgasbereich nur Inertgas- bzw. Edelgasionen auf die Anode. Dadurch bleibt die komplette Anlage frei von anodischem Niederschlag.

Ein Restniederschlag kann lediglich durch die nichtideale Funktion der beteiligten Baugruppen auftreten. Da das Elektronengate nicht supraleitend ist, sondern einen elektrischen Widerstand besitzt und die dielektrische Isolierung des Reaktivgasbereichs 10 keinen unendlichen Widerstand hat, wird ein gewisser Reststrom über die Isolierung fließen und zu geringen Ablagerungen führen. Zur weiteren Verringerung dieses Reststroms kann der Reaktivgasbereich 10, wie bereits erwähnt, aus der HF-Masse entfernt werden. Ebenfalls kann es in geringem Maße auch zur Anhaftung aktivierter Neutralteilchen kommen. Eine dünne, isolierende Schicht auf einer dicken dielektrischen Isolation beeinflusst die elektrischen Parameter der Entladung jedoch nicht.

Selbstverständlich ist die vorliegende Erfindung nicht auf einen derartigen geometrischen Aufbau begrenzt. Grundsätzlich sind beliebige Geometrien und Aufbauten möglich, die zu einer Aufteilung der Plasmasäule in einen reaktiven Bereich und einen inerten Bereich gemäß der vorliegenden Erfindung führen. Existierende Techniken und Technologien sind nach diesem Prinzip umrüstbar, solange sie nach dem Plasmaverfahren arbeiten (z.B. positive Selfbias, PVD und Sputtertechniken). Die folgenden Figuren zeigen weitere Beispiele für eine konstruktive Ausgestaltung der Vorrichtung gemäß der vorliegenden Erfindung.

In der Figur 4 ist ein Aufbau der Vorrichtung mit drei getrennten Kammern zu erkennen. Die Trenneinrichtung (Trennwände 9, Elektronengates 12) bildet hierbei eine dritte Kammer 17 zwischen dem Reaktivgasbereich 10 und dem Inertgasbereich 11. Dieses Dreikammerprinzip hat den Vorteil eines effektiver funktionierenden Elektronengates, da der Sperrgasfluss, d.h. der Fluss des Inertgases, unabhängig von den Prozessparametern eingestellt werden kann. Weiterhin kann der Pumpquerschnitt nahezu beliebig groß gewählt werden, wodurch ein zusätzlicher inerter Sperrgasfluss mehr als ausgeglichen werden kann. Das Einbringen von zusätzlichen Quellen, wie PVD-Magnetrons, PVD-Targets oder induktiv gekoppelter Plasmaquellen in den Reaktiv- und Inertgasbereich ist so einfacher realisierbar.

In der Figur 4 sind auch Zwischenringe 20 angedeutet, mit denen die durch die Kammerwand im Inertgasbereich 11 gebildete Gegenelektrode bei Bedarf in der Fläche skaliert werden kann. Die Skalierbarkeit ist erforderlich, wenn konstante Plasmadichten unabhängig von der Objektfläche der zu behandelnden Objekte realisiert werden sollen. Die Gegenelektrode (hier die auf Masse liegende Anode) muss hierzu in der Fläche flexibel ausgeführt werden. Durch das vorgeschlagene Zwischenringprinzip kann auch der isolierte Bereich der Anlage, der Reaktivgasbereich 10, an die unterschiedliche Größe von zu behandelnden Objekten bzw. Bauteilen angepasst werden. Der Inertgasbereich 11, der für die Erzeugung der notwendigen Selfbias verantwortlich ist, wird dann durch Nutzung geeigneter Zwischenringe so ausgeführt, dass die Flächenverhältnisse möglicher vorhergehender Prozesse (mit anderen Objekten) erhalten bleiben. Damit ist ein gewisses Maß an Skalierfähigkeit vorhanden, da in erster Näherung nur die Leistung entsprechend der vergrößerten/verkleinerten beglimmten Objektfläche und der Gasstrom für konstante Plasmaverweilzeiten der beteiligten Spezies verändert werden muss. Die für den Prozess notwendige Selfbiasspannung ist damit unabhängig von der für den Prozess notwendigen Plasmaverweildauer reaktiver Spezies einstellbar. Diese Möglichkeit der Skalierung ist sehr vorteilhaft, da es ansonsten nicht möglich ist, die Depositionsparameter aufgrund der auftretenden Plasmavolumenpolymerisation frei zu wählen. Plasmavolumenpolymerisation tritt häufig dann auf, wenn die Plasmaverweildauer der beteiligten Gasteilchen zu groß ist, da die Stoß- und damit die Reaktionswahrscheinlichkeit zunimmt.

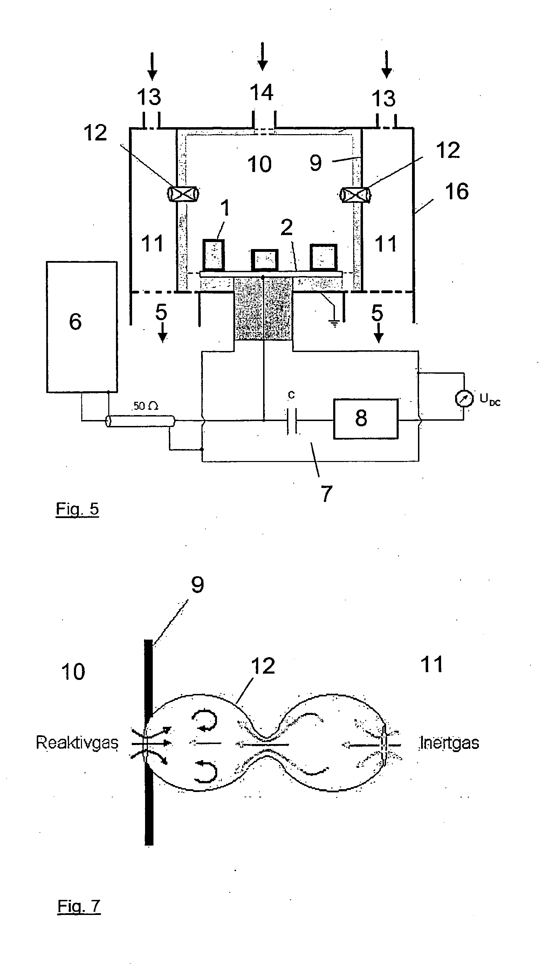

Figur 5 zeigt ein weiteres Beispiel für eine mögliche Ausgestaltung der vorliegenden Vorrichtung. Bei dieser Ausgestaltung sind die beiden Brennräume, Reaktivgasbereich 10 und Inertgasbereich 11, ineinander verschachtelt. Der Inertgasbereich 11 umschließt den Reaktivgasbereich 10 und ist mit diesem über mehrere Elektronengates 12 verbunden. Der innere Aufbau kann bei dieser Ausgestaltung bspw. aus Keramik oder Teflon gefertigt werden, ohne weitere HF-technische Probleme zu verursachen. Der HF-Strom kann weiterhin sauber auf der Innenseite der Plasmakammer 3 geführt werden. Um einen gewissen Anteil an Inertgas auch im Reaktivgasbereich 10 zu erreichen, kann es erforderlich sein, über die Zuführung für das Reaktivgas 14 auch ein oder mehrere Inertgase, bspw. Argon, einzuführen. Selbstverständlich kann hierfür auch eine getrennte Zuführung zum Reaktivgasbereich 10 vorgesehen sein.

Die Trenneinrichtung mit dem Elektronengate 12 ist ein wesentlicher Bestandteil der vorliegenden Vorrichtung. Das Elektronengate hat die Aufgabe, die beiden Plasmasäulen zu verbinden und einen nahezu ungehinderten Elektronenaustausch zu ermöglichen, ohne dass eine signifikante Rückdiffusion von Reaktivgasen in den Inertgasbereich stattfindet. Im einfachsten Fall kann es sich beim Elektronengate um ein einfaches Loch in einer Trennwand zwischen beiden Brennräumen handeln. Dieses Loch hat als theoretisch kleinsten Durchmesser, d.h. als untere Grenze für den Durchmesser, den Dunkelraumabstand. In einer derartigen einfachen Ausgestaltung wird jedoch keine optimale Diffusionssperre für die Reaktivgasteilchen erreicht.

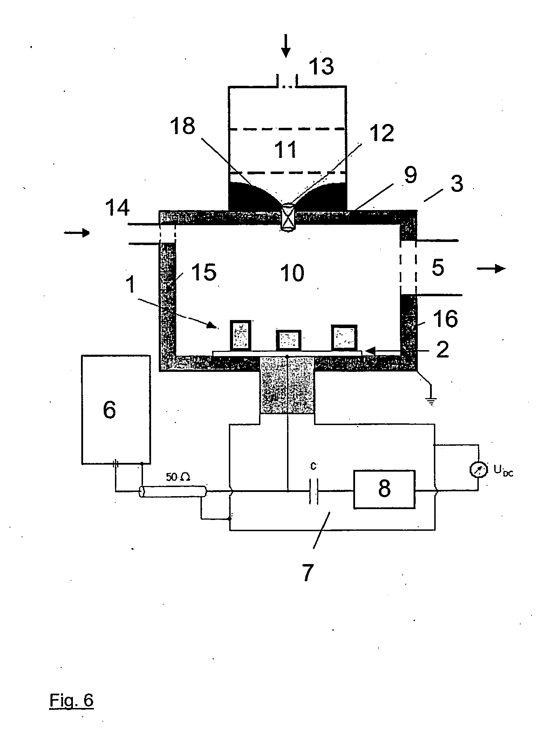

Die Wirkung als Diffusionssperre kann verbessert werden, indem der Strömungsquerschnitt des Inertgasbereichs 11 für das Inertgas kleiner als der des Reaktivgasbereichs 10 gewählt wird, wie dies in der Ausgestaltung der Figur 6 ersichtlich ist. Der Durchmesser des Reaktivgasbereichs 10 ist hierbei deutlich größer gewählt als der Durchmesser des Inertgasbereichs 11. Dadurch erhöht sich im Inertgasbereich der dynamische Druckanteil, wodurch die Diffusion von Reaktivgasanteilen in diesen Bereich behindert wird. Der gesamte Inertgasstrom muss hierbei jedoch laminar auf die Öffnung des Elektronengates 12 gerichtet werden. Zu diesem Zweck ist in der vorliegenden Ausgestaltung der Übergang zwischen dem Inertgasbereich 11 und dem Reaktivgasbereich 10 trichterförmig ausgebildet, wie dies durch das Bezugszeichen 18 angedeutet ist.

Figur 7 zeigt schließlich eine besonders vorteilhafte Ausgestaltung des Elektronengates 12 der Trenneinrichtung, die auch in diesem Beispiel als einfache Trennwand 9 ausgeführt ist. Das Elektronengate 12 wird hierbei über die Öffnung der Trennwand 9 montiert. Es weist zwei Bereiche mit größerem Querschnitt auf, im Folgenden als Strömungskammern bezeichnet, die durch einen Bereich mit verengtem Querschnitt miteinander verbunden sind. Die Ein- und Austrittsöffnungen aus den beiden Strömungskammern sind ebenfalls verengt, wie dies in der Figur zu erkennen ist. Diese Ausgestaltung, vergleichbar der Form einer Sanduhr, bildet eine besonders gute Diffusionssperre für das Reaktivgas. Der Inertgasstrom wird auf seinem Weg in den Reaktivgasbereich dreimal verengt und damit auch dreimal beschleunigt. Der Bereich zwischen den Strömungskammern kann nur von Teilchen passiert werden, die eine senkrechte (normale) Flugrichtung aufweisen (bei (senkrechter Durchströmungsrichtung), was diesen Bereich als Diffusionssperre besonders effektiv macht. Alle neutralen Gasteilchen deren Bewegungsrichtung vom direkten (normalen) Weg abweicht, werden zuerst von den Gatewänden reflektiert und anschließend von der "laminaren Inertgasströmung" erfasst und in den Reaktivgasbereich zurück-gedrängt. In der vorderen Kammer trifft diese laminare Inertgasströmung auf den geringen Reaktivgasgegenstrom aus dem Reaktivgasbereich 10. In dieser Strömungskammer muss daher mit geringen Ablagerungen von angeregten Reaktivgaskomponenten gerechnet werden. Vorzugsweise wird dieses Elektronengate 12 daher annähernd waagrecht angeordnet, wie in der Figur dargestellt, so dass sich die Ablagerungen in einem unteren Bereich der Strömungskammer sammeln, in dem sie weder elektrisch noch chemisch störend wirken können.

Die Trenneinrichtung kann hierbei über mehrere Elektronengates 12, bspw. über zwei Elektronengates 12, verfügen, um einen geringeren elektrischen Übergangswiderstand zwischen den Brennräumen zu erreichen. Auch hier kann zusätzlich eine trichterförmige Zuführung des Inertgases zum Elektronengate 12 vorgesehen sein. Dies ist jedoch nicht zwangsläufig notwendig.

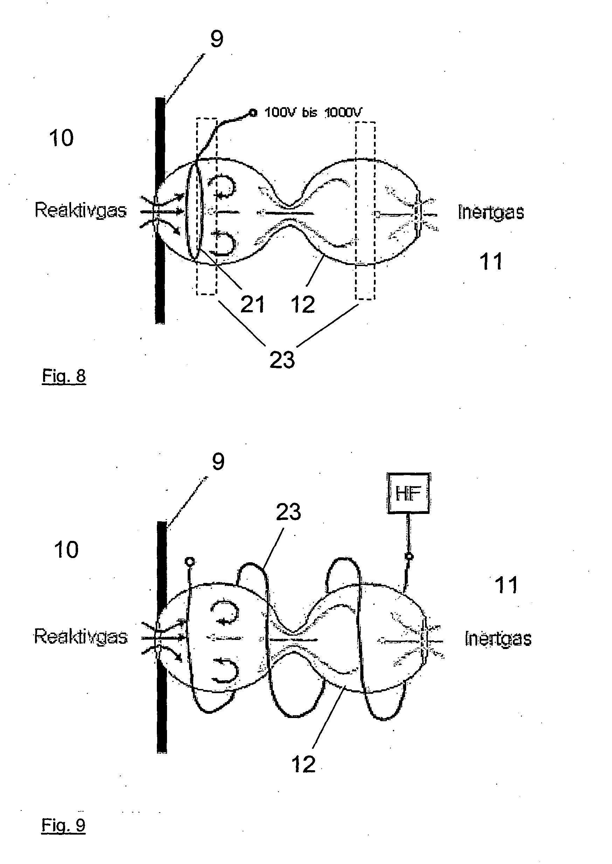

Die Figuren 8 und 9 zeigen weitere Beispiele für besonders vorteilhafte Ausgestaltungen des Elektronengates 12 der Trenneinrichtung, bei denen im Bereich des Elektronengates eine zusätzliche Plasmaquelle angeordnet ist.

Figur 8 zeigt hierbei ein aktives Elektronengate, um das eine DC-Ringelektrode 21 angeordnet ist. Als Gegenelektrode fungiert die geerdete Kesselwand des Inertgasbereichs. Durch diese Ringelektrode 21 wird eine zusätzliche Plasmaquelle im Elektronengate geschaffen, durch die der Widerstand für den das Elektronengate passierenden HF-Strom herabgesetzt wird.

Um Ablagerungen im Mündungsbereich des Elektronengates zu vermeiden, wird eine Helmholtzspule 22 (hier nur schematisch angedeutet) über das Elektronengate geschoben. Das durch dass Elektronengate greifende homogene Magnetfeld hindert Ladungsträger am Verlassen der Plasmasäule zwischen Inertgas- und Reaktivgasbereich und verbessert noch einmal die elektrische Leitfähigkeit innerhalb des Elektronengates für die HF.

Eine weitere geeignete Möglichkeit, ein aktives Elektronengate zu erhalten, ist die Erzeugung eines induktiv gekoppelten HF-Plasmas innerhalb des Elektronengates, wie dies in Figur 9 gezeigt ist. Hierzu wird das Elektronengate mit einer geeigneten Spule 23 bedeckt, die mit einem hochfrequenten Strom versorgt wird. Die Gegenelektrode ist auch hier die geerdete Kammerwand des Inergasbereichs.

Bezugszeichenliste

| | |
|---|---|
| 1 | Objekte |
| 2 | Elektrode |
| 3 | Plasmakammer |
| 4 | Zuführung |
| 5 | Abführung zur Pumpe |
| 6 | HF-Generator |
| 7 | Anpassungsschaltung |
| 8 | Filter |
| 9 | Trennwand |
| 10 | Reaktivgasbereich |
| 11 | Inertgasbereich |
| 12 | Elektronengate/Diffusionssperre |
| 13 | Zuführung für Inertgas |
| 14 | Zuführung für Reaktivgas |
| 15 | Isolierung |
| 16 | Aluminium bzw. Edelstahl |
| 17 | dritte Kammer |
| 18 | trichterförmige Zuführung |
| 20 | Zwischenringe |
| 21 | DC-Ringelektrode |
| 22 | Helmholtzspule |
| 23 | Spule |

**Patentansprüche**

1. Vorrichtung zur Plasmabehandlung von Objekten, mit einer Plasmakammer (3), in der zumindest eine Elektrode (2) als Objektträger angeordnet ist und zumindest ein Wandbereich der Plasmakammer (3) und/oder zumindest ein in der Plasmakammer (3) angeordnetes Bauteil eine Gegenelektrode bildet, und einer mit der Elektrode (2) verbundenen Hochfrequenzeinheit (6), mit der durch Anlegen einer hochfrequenten Wechselspannung zwischen Elektrode (2) und Gegenelektrode ein Plasma in der Plasmakammer (3) erzeugbar ist, wobei die Plasmakammer(3) durch eine Trenneinrichtung (9, 12) in zumindest zwei Teilvolumina aufgeteilt ist, von denen ein erstes Teilvolumen (10) für ein Reaktivgas die Elektrode (2) und ein zweites Teilvolumen (11) für ein Inertgas einen bei der Plasmaerzeugung aktiven Bereich der Gegenelektrode beinhalten, und wobei die Trenneinrichtung (9, 12) geeignet ist, einen für die Erzeugung des Plasmas erforderlichen Elektronenaustausch im Plasma zwischen den Teilvolumina (10, 11) zu ermöglichen und eine Diffusionssperre für das Reaktivgas zu bilden.

2. Vorrichtung nach Anspruch 1,
**dadurch gekennzeichnet,**
**dass** die Trenneinrichtung (9, 12) durch zumindest eine Trennwand (9) mit zumindest einer Durchlassöffnung für den Elektronenaustausch gebildet ist.

3. Vorrichtung nach Anspruch 2,
**dadurch gekennzeichnet,**
**dass** die Plasmakammer (3) getrennte Zufuhröffnungen (13, 14) für ein Inertgas und für ein Reaktivgas aufweist, wobei die Zufuhröffnung(en) (13) für das Inertgas in das zweite Teilvolumen (11) und die Zufuhröffnung(en) (14) für das Reaktivgas in das erste Teilvolumen (10) münden.

4. Vorrichtung nach Anspruch 2 und 3,
**dadurch gekennzeichnet,**
**dass** die Zufuhröffnungen (13, 14) und die Durchlassöffnung so ausgebildet und angeordnet sind, dass eine Diffusion des Reaktionsgases und reaktiver Bestandteile des Plasmas vom ersten (10) in das zweite Teilvolumen (11) durch kontinuierliches Zuführen und Abpumpen des Inertgases im wesentlichen verhindert werden kann.

5. Vorrichtung nach einem der Ansprüche 2 bis 4,
**dadurch gekennzeichnet,**
**dass** die Durchlassöffnung auf Seite des zweiten Teilvolumens (11) eine trichterförmige Zuführung (18) aufweist, das sich zur Durchlassöffnung hin verengt.

6. Vorrichtung nach einem der Ansprüche 2 bis 4,
**dadurch gekennzeichnet,**
**dass** die Durchlassöffnung mit einem Durchströmungselement (12) verbunden ist, das einen Strömungskanal zwischen zweitem (11) und erstem Teilvolumen (10) bildet, der zwischen Ein- und Ausströmöffnung zwei hintereinander geschaltete Strömungskammern aufweist, die über eine Strömungsverengung miteinander verbunden sind.

7. Vorrichtung nach Anspruch 6,
   **dadurch gekennzeichnet,**
   **dass** die Trennwand (9) annähernd senkrecht und das Durchströmungselement (12) annähernd waagrecht angeordnet sind.

8. Vorrichtung nach einem der Ansprüche 2 bis 7,
   **dadurch gekennzeichnet,**
   **dass** im Bereich der Durchlassöffnung eine weitere Plasmaquelle angeordnet ist.

9. Vorrichtung nach Anspruch 8,
   **dadurch gekennzeichnet,**
   **dass** die weitere Plasmaquelle durch eine Elektrode (21) erzeugt wird, die mit einer Gleichspannungsquelle verbunden ist.

10. Vorrichtung nach Anspruch 8 oder 9,
    **dadurch gekennzeichnet,**
    **dass** im Bereich der Durchlassöffnung eine Einrichtung zur Erzeugung eines statischen Magnetfeldes angeordnet ist, durch das die Wahrscheinlichkeit für ein Auftreffen von Elektronen und Ionen auf Randbereiche der Durchgangsöffnung und/oder auf eine Innenwand eines mit der Durchgangsöffnung verbundenen Durchströmungselementes (12) verringert wird.

11. Vorrichtung nach Anspruch 10,
    **dadurch gekennzeichnet,**
    **dass** die Einrichtung zur Erzeugung des statischen Magnetfeldes zumindest eine Helmholtzspule (22) umfasst.

12. Vorrichtung nach einem der Ansprüche 1 bis 11,
    **dadurch gekennzeichnet,**
    **dass** um das erste Teilvolumen (10) zumindest im Bereich der Elektrode (2) ein oder mehrere Helmholtzspulen zur Erzeugung eines statischen Magnetfeldes angeordnet sind, das die Wahrscheinlichkeit für ein Auftreffen von Elektronen und Ionen auf Wandbereiche der Plasmakammer (3) im ersten Teilvolumen (10) verringert.

13. Vorrichtung nach einem der Ansprüche 1 bits 12,
    **dadurch gekennzeichnet,**
    **dass** die Plasmakammer (3) im ersten Teilvolumen (10) Wände aus einem isolierenden Material oder Wände aufweist, die mit einem isolierenden Material bedeckt sind.

14. Vorrichtung nach einem der Ansprüche 1 bis 13,
    **dadurch gekennzeichnet,**
    **dass** die Plasmakammer (3) im ersten Teilvolumen (10) Wände aufweist, die elektrisch nicht mit der Gegenelektrode oder mit Masse verbunden sind.

15. Vorrichtung nach einem der Ansprüche 1 bis 14,
    **dadurch gekennzeichnet,**
    **dass** die Plasmakammer (3) so ausgebildet ist, dass das das zweite (11) und optional auch das erste Teilvolumen (10), insbesondere durch Einsetzen von Zwischenringen (20), im Volumen veränderbar sind.

16. Vorrichtung nach einem der Ansprüche 1 bis 15,
    **dadurch gekennzeichnet,**
    **dass** die Plasmakammer (3) durch die Trenneinrichtung (9, 12) in drei Teilvolumina aufgeteilt ist, wobei ein drittes Teilvolumen (17) zwischen dem ersten (10) und dem zweiten Teilvolumen (11) ausgebildet ist und zumindest eine Öffnung zum Abpumpen von Gasen aufweist.

17. Vorrichtung nach einem der Ansprüche 1 bis 15,
    **dadurch gekennzeichnet,**
    **dass** das erste Teilvolumen (10) vom zweiten Teilvolumen (9) umschlossen ist.

18. Verfahren zur Plasmabehandlung von Objekten, bei dem durch Anlegen einer hochfrequenten Wechselspannung zwischen zumindest einer Elektrode (2) und zumindest einer Gegenelektrode ein Plasma erzeugt und eine Oberfläche ein oder mehrerer auf der Elektrode (2) gelagerter Objekte (1) durch aus dem Plasma auf die Oberfläche auftreffende reaktive Ionen behandelt, insbesondere beschichtet oder geätzt wird, wobei

    - das Plasma durch eine Trenneinrichtung (9, 12) in zumindest zwei Teilvolumina unterteilt wird, von denen ein zur Elektrode (2) offenes erstes Teilvolumen (10) durch Einleiten oder Erzeugen eines Reaktivgases hauptsächlich reaktive Bestandteile des Plasmas und ein zur Gegenelektrode offenes zweites Teilvolumen (11) durch Einleiten eines Inertgases hauptsächlich inerte Bestandteile des Plasmas umfassen,
    - ein für die Erzeugung des Plasmas erforderlicher Elektronenaustausch im Plasma zwischen den Teilvolumina (10, 11) durch die Trenneinrichtung (9, 12) ermöglicht und
    - die Diffusion des Reaktivgases und der reaktiven Bestandteile in das zweite Teilvolumen (11) im wesentlichen verhindert wird.

19. Verfahren nach Anspruch 18,
    **dadurch gekennzeichnet,**
    **dass** die Diffusion des Reaktivgases und der reaktiven Bestandteile in das zweite Teilvolumen (11) durch kontinuierliches Zuführen des Inertgases in das zweite Teilvolumen (11) im wesentlichen verhindert wird.

20. Verfahren nach Anspruch 18 oder 19,
**dadurch gekennzeichnet,**
**dass** als Trenneinrichtung (9, 12) zumindest eine Trennwand (9) eingesetzt wird, die zumindest eine Durchlassöffnung für den Elektronenaustausch aufweist.

21. Verfahren nach Anspruch 20,
**dadurch gekennzeichnet,**
**dass** im Bereich der für den Elektronenaustausch im Plasma zwischen den Teilvolumina (10, 11) vorgesehenen Durchlassöffnung der Trenneinrichtung und/oder eines mit der Durchlassöffnung verbundenen Durchströmungselementes (12) eine weitere Plasmaquelle angeordnet wird, mit deren Hilfe die elektrische Leitfähigkeit des Plasma in der Durchlassöffnung und/oder dem Durchströmungselement (12) erhöht wird.

22. Verfahren nach Anspruch 21,
**dadurch gekennzeichnet,**
**dass** ein statisches Magnetfeldes im Bereich der Durchlassöffnung und/oder des Durchströmungselementes (12) erzeugt wird, durch das die Wahrscheinlichkeit für ein Auftreffen von Elektronen und Ionen auf Randbereiche der Durchgangsöffnung und/oder auf eine Innenwand des Durchströmungselementes (12) verringert wird.

23. Verfahren nach einem der Ansprüche 18 bis 22,
**dadurch gekennzeichnet,**
**dass** mit einer oder mehreren Helmholtzspulen ein statisches Magnetfeld im ersten Teilvolumen (10) zumindest im Bereich der Elektrode (2) erzeugt wird, das die Wahrscheinlichkeit für ein Auftreffen von Elektronen und Ionen auf Wandbereiche der Plasmakammer (3) verringert.

**Claims**

1. A device for the plasma treatment of objects, with a plasma chamber (3) in which at least one electrode (2) is arranged as object carrier and at least one wall region of the plasma chamber (3) and/or at least one component arranged in the plasma chamber (3) forms a counter electrode, and a high frequency unit (6) which is connected to the electrode (2), using which high frequency unit a plasma can be generated in the plasma chamber (3) by applying a high-frequency AC voltage between the electrode (2) and the counter electrode,
wherein the plasma chamber (3) is divided by a dividing apparatus (9, 12) into at least two part volumes of which a first part volume (10) contains the electrode (2) for a reactive gas and a second part volume (11) contains a region of the counter electrode for an inert gas, which region is active during the plasma generation, and wherein the dividing apparatus (9, 12) is suitable to enable electron exchange, which is required for the generation of the plasma, in the plasma between the part volumes (10, 11) and to form a diffusion barrier for the reactive gas.

2. The device according to Claim 1,
**characterized**
**in that** the dividing apparatus (9, 12) is formed by at least one dividing wall (9) with at least one transmission opening for the electron exchange.

3. The device according to Claim 2,
**characterized**
**in that** the plasma chamber (3) has divided supply openings (13, 14) for an inert gas and for a reactive gas, wherein the supply opening(s) (13) for the inert gas open(s) into the second part volume (11) and the supply opening(s) (14) for the reactive gas open into the first part volume (10).

4. The device according to Claims 2 and 3,
**characterized**
**in that** the supply openings (13, 14) and the transmission opening are configured and arranged so that diffusion of the reactive gas and reactive constituents of the plasma from the first (10) into the second part volume (11) can substantially be hindered by continuous supply and pumping away of the inert gas.

5. The device according to one of Claims 2 to 4,
**characterized**
**in that** the transmission opening has a funnel-shaped supply (18) on the second part volume (11) side, which supply narrows towards the transmission opening.

6. The device according to one of Claims 2 to 4,
**characterized**
**in that** the transmission opening is connected to a throughflow element (12) which forms a flow channel between the second (11) and first part volume (10), which flow channel has two flow chambers connected in series between the inflow and outflow openings, which flow chambers are connected with one another via a flow constriction.

7. The device according to Claim 6,
**characterized**
**in that** the dividing wall (9) is arranged approximately vertically and the throughflow element (12) is arranged approximately horizontally.

8. The device according to one of Claims 2 to 7,
**characterized**
**in that** a further plasma source is arranged in the region of the transmission opening.

9. The device according to Claim 8,
   **characterized**
   **in that** the further plasma source is generated by an electrode (21) which is connected to a DC voltage source.

10. The device according to Claim 8 or 9,
    **characterized**
    **in that** an apparatus for generating a static magnetic field is arranged in the region of the transmission opening, by means of which magnetic field the likelihood of electrons and ions impinging on edge regions of the passage opening and/or on an inner wall of a throughflow element (12), which is connected to the passage opening, is reduced.

11. The device according to Claim 10,
    **characterized**
    **in that** the apparatus for generating the static magnetic field comprises at least one Helmholtz coil (22).

12. The device according to one of Claims 1 to 11,
    **characterized**
    **in that** one or a plurality of Helmholtz coils for generating a static magnetic field, which magnetic field reduces the likelihood of electrons and ions impinging on wall regions of the plasma chamber (3) in the first part volume (10), are arranged around the first part volume (10) at least in the region of the electrode (2).

13. The device according to one of Claims 1 to 12,
    **characterized**
    **in that** the plasma chamber (3) in the first part volume (10) has walls made from an insulating material or has walls which are coated with an insulating material.

14. The device according to one of Claims 1 to 13,
    **characterized**
    **in that** the plasma chamber (3) in the first part volume (10) has walls which are not electrically connected to the counter electrode or to earth.

15. The device according to one of Claims 1 to 14,
    **characterized**
    **in that** the plasma chamber (3) is configured in such a manner that the volume of the second (11) and optionally also the first part volume (10) can be changed, particularly by using spacing rings (20).

16. The device according to one of Claims 1 to 15,
    **characterized**
    **in that** the plasma chamber (3) is divided into three part volumes by the dividing apparatus (9, 12), wherein a third volume (17) is formed between the first (10) and the second part volume (11) and has at least one opening for pumping away gases.

17. The device according to one of Claims 1 to 15,
    **characterized**
    **in that** the first part volume (10) is enclosed by the second part volume (9).

18. A method for plasma treatment of objects, in which a plasma is generated by applying a high-frequency AC voltage between at least one electrode (2) and at least one counter electrode, and a surface of one or a plurality of objects (1) laid on the electrode (2) is treated, particularly coated or etched, by reactive ions impinging on the surface from the plasma, wherein

    - the plasma is divided into at least two part volumes by a dividing apparatus (9, 12), of which part volumes, one first part volume (10), which is open to the electrode (2), primarily comprises reactive constituents of the plasma as a result of the introduction or generation of a reactive gas, and one second part volume (11), which is open to the counter electrode, primarily comprises inert constituents of the plasma as a result of the introduction of an inert gas,
    - an electron exchange which is required for generating the plasma is enabled in the plasma between the part volumes (10, 11) by the dividing apparatus (9, 12) and
    - the diffusion of the reactive gas and of the reactive constituents into the second part volume (11) is substantially hindered.

19. The method according to Claim 18,
    **characterized in that** the diffusion of the reactive gas and of the reactive constituents into the second part volume (11) is substantially hindered by continuous supply of the inert gas into the second part volume (11).

20. The method according to Claim 18 or 19,
    **characterized**
    **in that** at least one dividing wall (9) is used as dividing apparatus (9, 12), which wall has at least one transmission opening for the electron exchange.

21. The method according to Claim 20,
    **characterized**
    **in that** in the region of the transmission opening of the dividing apparatus, which transmission opening is provided between the part volumes (10, 11) for the electron exchange in the plasma, and/or in the region of a throughflow element (12), which is connected to the transmission opening, a further plasma source is arranged, with the aid of which the electrical conductivity of the plasma in the transmission opening and/or the throughflow element (12) is increased.

**22.** The method according to Claim 21, **characterized in that** a static magnetic field is generated in the region of the transmission opening and/or of the throughflow element (12), by means of which magnetic field the likelihood of electrons and ions impinging on edge regions of the passage opening and/or on an inner wall of the throughflow element (12) is reduced.

**23.** The method according to one of Claims 18 to 22, **characterized in that** a static magnetic field is generated in the first part volume (10) at least in the region of the electrode (2) with one or a plurality of Helmholtz coils, which magnetic field reduces the likelihood of electrons and ions impinging on wall regions of the plasma chamber (3).

**Revendications**

**1.** Dispositif de traitement au plasma d'objets, comportant une chambre de plasma (3), dans laquelle au moins une électrode (2) est disposée en tant que support d'objet et au moins une portion de paroi de la chambre de plasma (3) et/ou au moins un composant disposé dans la chambre de plasma forme une contre-électrode, et comportant une unité à haute fréquence (6) reliée à l'électrode (2), avec laquelle en appliquant une tension alternative à haute fréquence entre l'électrode (2) et la contre-électrode un plasma peut être généré dans la chambre de plasma (3),

moyennant quoi la chambre de plasma (3) est divisée par un dispositif de séparation (9,12) en au moins deux volumes partiels, desquels un premier volume partiel (10) d'un gaz réactif contient l'électrode (2) et un deuxième volume partiel (11) d'un gaz inerte contient une région active lors de la génération de plasma de la contre-électrode, et moyennant quoi le dispositif de séparation (9,12) est approprié afin de permettre un échange d'électrons dans le plasma entre les volumes partiels (10,11) requis pour la génération du plasma et de former une barrière de diffusion pour le gaz réactif.

**2.** Dispositif selon la revendication 1, **caractérisé en ce que** le dispositif de séparation (9,12) est formé par au moins une paroi de séparation (9) comportant au moins une ouverture de passage pour l'échange d'électrons.

**3.** Dispositif selon la revendication 2, **caractérisé en ce que**

la chambre de plasma (3) présente des ouvertures d'introduction (13,14) séparées pour un gaz inerte et pour un gaz réactif, moyennant quoi la (les) ouverture(s) d'introduction (13) du gaz inerte débouchent dans le deuxième volume partiel (11) et la(les) ouverture(s) d'introduction (14) du gaz réactif débouchent dans le premier volume partiel (10).

**4.** Dispositif selon la revendication 2 et 3, **caractérisé en ce que** les ouvertures d'introduction (13,14) et l'ouverture de passage sont configurées et disposées de telle sorte que une diffusion du gaz de réaction et des composants réactifs du plasma du premier (10) dans le deuxième volume partiel (11) puisse être essentiellement empêchée en introduisant et pompant en continu du gaz inerte.

**5.** Dispositif selon une des revendications 2 à 4, **caractérisé en ce que** l'ouverture de passage présente du côté du deuxième volume partiel (11) un dispositif d'alimentation (18) en forme d'entonnoir, qui se rétrécit en allant vers l'ouverture de passage.

**6.** Dispositif selon une des revendications 2 à 4, **caractérisé en ce que** l'ouverture de passage est reliée à un élément d'écoulement (12), qui forme un canal d'écoulement entre le deuxième (11) et le premier volume partiel (10), qui présente deux chambres d'écoulement disposées l'une derrière l'autre entre l'ouverture d'entrée d'écoulement et l'ouverture de sortie d'écoulement, lesquelles chambres sont reliées via un rétrécissement de l'écoulement.

**7.** Dispositif selon la revendication 6, **caractérisé en ce que** la paroi de séparation (9) est disposée approximativement à la perpendiculaire et l'écoulement de passage d'écoulement (12) est disposé approximativement à l'horizontale.

**8.** Dispositif selon une des revendications 2 à 7, **caractérisé en ce que** au niveau de l'ouverture de passage, une autre source de plasma est disposée.

**9.** Dispositif selon la revendication 8, **caractérisé en ce que** l'autre source de plasma est générée par une électrode (21), qui est reliée à une source de tension continue.

**10.** Dispositif selon la revendication 8 ou 9, **caractérisé en ce que** au niveau de l'ouverture de passage, un dispositif de génération d'un champ magnétique statique est disposé, par l'intermédiaire duquel la probabilité d'une collision des électrons et des ions sur les zones de bord de l'ouverture de passage et/ou sur une paroi interne d'un élément de passage d'écoulement (12) relié à l'ouverture de passage est diminuée.

**11.** Dispositif selon la revendication 10,
**caractérisé en ce que**
le dispositif de génération du champ magnétique statique comprend au moins une bobine de Helmholtz (22).

**12.** Dispositif selon une des revendications 1 à 11,
**caractérisé en ce que**
autour du premier volume partiel (10), au moins au niveau de l'électrode (2), une ou plusieurs bobines de Helmholtz sont disposées afin de générer un champ magnétique statique, qui diminue la probabilité d'une collision des électrons et des ions sur des zones de paroi de la chambre de plasma (3) dans le premier volume partiel (10).

**13.** Dispositif selon une des revendications 1 à 12,
**caractérisé en ce que**
la chambre de plasma (3) présente dans le premier volume partiel (10) des parois en un matériau isolant ou des parois, qui sont recouvertes d'un matériau isolant.

**14.** Dispositif selon une des revendications 1 à 13,
**caractérisé en ce que**
la chambre de plasma (3) présente dans le premier volume partiel (10) des parois, qui ne sont pas reliées électriquement à la contre-électrode ou à la masse.

**15.** Dispositif selon une des revendications 1 à 14,
**caractérisé en ce que**
la chambre de plasma (3) est configurée de telle sorte que le deuxième (11) et optionnellement aussi le premier volume partiel (10) peuvent être variés en volume, notamment en insérant des bagues intermédiaires (20).

**16.** Dispositif selon une des revendications 1 à 15,
**caractérisé en ce que**
la chambre de plasma (3) est divisée par le dispositif de séparation (9,12) en trois volumes partiels, moyennant quoi un troisième volume partiel (17) est réalisé entre le premier (10) et le deuxième volume partiel (11) et présente au moins une ouverture pour le pompage de gaz.

**17.** Dispositif selon une des revendications 1 à 15,
**caractérisé en ce que**
le premier volume partiel (10) est enveloppé par le deuxième volume partiel (9).

**18.** Procédé de traitement au plasma d'objets, dans lequel en appliquant une tension alternative à haute fréquence entre au moins une électrode (2) et au moins une contre-électrode, un plasma est généré et une surface d'un ou plusieurs objets (1) placés sur l'électrode (2) est traitée par les ions réactifs du plasma entrant en collision avec la surface, notamment revêtu ou décapé, moyennant quoi

    - le plasma est divisé par un dispositif de séparation (9,12) en au moins deux volumes partiels, desquels un premier volume partiel (10) ouvert dans la direction de l'électrode (2) comprend principalement des composants réactifs du plasma en induisant ou générant un gaz réactif et un deuxième volume partiel (11) ouvert dans la direction de la contre-électrode comprend principalement des composants inertes du plasma en induisant un gaz inerte,
    - un échange d'électrons nécessaire pour la génération du plasma est rendu possible dans le plasma entre les volumes partiels (10,11) par le dispositif de séparation (9,12) et
    - la diffusion du gaz réactif et des composants réactifs dans le deuxième volume partiel (11) est essentiellement empêché.

**19.** Procédé selon la revendication 18,
**caractérisé en ce que**
la diffusion du gaz réactif et des composants réactifs dans le deuxième volume partiel (11) est essentiellement empêché en introduisant en continu du gaz inerte dans le deuxième volume partiel (11).

**20.** Procédé selon la revendication 18 ou 19,
**caractérisé en ce que**
comme dispositif de séparation (9,12), au moins une paroi de séparation (9) est employée, laquelle présente au moins une ouverture de passage pour l'échange des électrons.

**21.** Procédé selon la revendication 20,
**caractérisé en ce que**
au niveau de l'ouverture de passage du dispositif de séparation prévue entre les volumes partiels (10,11) pour l'échange d'électrons dans le plasma et/ou un élément de passage d'écoulement (12) relié à l'ouverture de passage, une autre source de plasma est disposée, à l'aide de laquelle la conductivité électrique du plasma dans l'ouverture de passage et/ou l'élément de passage d'écoulement (12) est augmentée.

**22.** Procédé selon la revendication 21,
**caractérisé en ce que**
un champ magnétique statique est généré au niveau de l'ouverture de passage et/ou de l'élément de passage d'écoulement (12), par l'intermédiaire duquel la probabilité d'une collision des électrons et des ions sur les zones de bord de l'ouverture de passage et/ou sur une paroi intérieure de l'élément de passage d'écoulement (12) est diminuée.

23. Procédé selon une des revendications 18 à 22, **caractérisé en ce que** avec une ou plusieurs bobines de Helmholtz, un champ magnétique statique est généré dans le premier volume partiel (10) au moins au niveau de l'électrode (2), lequel diminue la probabilité d'une collision des électrons et des ions sur des zones de paroi de la chambre de plasma (3).

Fig. 1 (Stand der Technik)

$$U_{sb} = U_A - U_B$$

Fig. 2 (Stand der Technik)

Fig. 3

Fig. 4

Fig. 5

Fig. 7

Fig. 6

9

10

Reaktivgas

100V bis 1000V

Inertgas

11

21    12

23

Fig. 8

9

10

23

HF

Reaktivgas

Inertgas

11

12

Fig. 9

## IN DER BESCHREIBUNG AUFGEFÜHRTE DOKUMENTE

**In der Beschreibung aufgeführte Patentdokumente**

- JP 58064023 A
- JP 10083899 A